**Europäisches Patentamt**

**European Patent Office**

**Office européen des brevets**

(11) Veröffentlichungsnummer: **0 207 063**
**B1**

(12) **EUROPÄISCHE PATENTSCHRIFT**

(45) Veröffentlichungstag der Patentschrift:
**20.12.89**

(51) Int. Cl.⁴: **A 43 C 15/16**, A 43 B 5/00

(21) Anmeldenummer: **86890171.1**

(22) Anmeldetag: **10.06.86**

(54) **Golfschuh.**

(30) Priorität: **18.06.85 AT 1803/85**

(43) Veröffentlichungstag der Anmeldung:
**30.12.86 Patentblatt 86/52**

(45) Bekanntmachung des Hinweises auf die Patenterteilung:
**20.12.89 Patentblatt 89/51**

(84) Benannte Vertragsstaaten:
**BE CH DE FR GB IT LI LU NL SE**

(56) Entgegenhaltungen:
**DE-A- 3 014 254**
**DE-A- 3 046 811**
**DE-B- 1 235 186**
**DE-C- 930 798**
**GB-A- 216 376**
**GB-A- 407 499**
**US-A- 303 287**
**US-A- 3 324 578**
**US-A- 4 271 608**

(73) Patentinhaber: **Hartjes, Anna Maria, Lukasberg 8,**
**A-4843 Ampflwang (Oberösterreich) (AT)**

(72) Erfinder: **Hartjes, Rudolf, verstorben, (AT)**
Erfinder: **Gräber, Gunter, Klosterstrasse 4,**
**D-6732 Edenkoben (DE)**

(74) Vertreter: **Hübscher, Gerhard, Dipl.-Ing. et al,**
**Patentanwälte Dipl.-Ing. Gerhard Hübscher Dipl.-Ing.**
**Helmut Hübscher Dipl.-Ing. Heiner Hübscher**
**Spittelwiese 7, A-4020 Linz (AT)**

ACTORUM AG

## Beschreibung

Die Erfindung bezieht sich auf einen Golfschuh mit spikebestückter Sohle, wobei die aus Schaft und Druckplatte bestehenden Spikes sich axialbeweglich über die Druckplatte an einem federelastischen Widerlager abstützen und mit ihrem Schaft in Durchlaßöffnungen der Sohle eingreifen.

Beim Golfsport kommt es durch das Schlagen des Balles und durch das oft kilometerweise Gehen zu zwei sehr unterschiedlichen Bewegungsabläufen, und ein guter Golfschuh muß daher auch einerseits dem Spieler einen festen Halt für die Schlagbewegung bieten und anderseits dem Fuß als bequeme Stütze für die Gehbewegung dienen. Um die Standsicherheit des Spielers zu erhöhen, ist es bekannt, die Schuhsohle mit den verschiedensten Nägeln oder Spikes zu besetzen, und, um die Spikes sauber halten zu können oder sie je nach Bodenbeschaffenheit mehr oder weniger stark zur Wirkung kommen zu lassen, wurde gemäß der US-A-4 271 608 oder der DE-C-930 798 auch schon vorgeschlagen, die Spikes in ein federelastisches Widerlager einzubetten. Diese Spikes sind aber mit ihrer Druckplatte unten an der Sohle befestigt und die Widerlagerschicht ist ebenfalls an der Sohlenunterseite angesetzt, was eine Relativbewegung zwischen Spikes und Sohle ausschließt und die Belastung durch die vergleichmäßigende Wirkung der Sohle auf alle Flächenbereiche der Sohle überträgt, so daß ein bedarfsweise individueller Einsatz der einzelnen Spikes unmöglich ist. Das Ein- und Ausfahren der Spikes aus dem Widerlager kann daher beispielsweise nicht speziell auf die eigenartige Dreh- und Abrollbewegung des Fußes während eines Schlages beim Golfspiel abgestimmt werden und auch die Gehbewegung bleibt durch die direkt an der Sohle angreifenden Spikes beeinträchtigt, die vor allem bei längerem Gehen zu unangenehmen Ermüdungserscheinungen im Fuß führen. Abgesehen davon ist die Widerlagerschicht an der Sohlenunterseite dem Bodenkontakt und anderen äußeren Einflüssen ausgesetzt und leicht zu beschädigen, was auch durch eine zusätzliche äußere Schutzschicht, die noch dazu versteifend wirkt, kaum verhindert werden kann.

Ähnliche Verhältnisse für den Spikeeinsatz ergeben sich, wenn die Spikes gemäß der DE-A-3 046 811 fest in die Sohle eingeschraubt und mit einem federnd abgestützten gelochten Stoppel versehen sind, nur wird hier durch die Stoppeln das Gehen auf Dauer noch beschwerlicher.

Aus der GB-A-216 376 ist weiters ein Sportschuh bekannt, der im Vorderfußbereich eine Doppelsohle zur Ausbildung eines mehrere Spikes und Stützfedern aufnehmenden Luftpolsters aufweist. Die Spikes sind mit ihrer Druckplatte unterseitig an der Innensohle angesetzt und ihr von den Stützfedern umgebener Schaft ragt in Durchlaßöffnungen der Außensohle vor, wobei Luftlöcher der Außensohle den Luftpolster mit der Außenluft verbinden. Diese Doppelsohle soll einen weich-elastischen, federnden Auftritt beim Gehen und Laufen vermitteln und die Schrittlänge vergrößern helfen, sie kann aber keinesfalls wegen ihrer instabilen Luftpolsterwirkung eine Stützfunktion für eine Schlagbewegung erfüllen.

Außerdem ist der Luftpolster durch die Luftlöcher recht verschmutzungsanfällig und wird bei Verschmutzung unwirksam und die Spikes lassen sich aufgrund der die auftretenden Belastungen vergleichmäßigenden Innensohle nur gemeinsam und nicht individuell ausfahren.

Wie die DE-A-3 014 254 zeigt, gibt es auch in Bohrungen des Schuhabsatzes geführte, über Druckfedern abgestützte Spikenägel, die mittels Druckstollen betätigbar und mittels Einschiebeblech sperrbar sind, doch entsteht dabei eine aufwendige, platzraubende Konstruktion, deren Funktionstüchtigkeit sehr in Frage steht und für die Sportschuhe, insbesondere für Golfschuhe, vollkommen ungeeignet ist.

Der Erfindung liegt daher die Aufgabe zugrunde, diese Mängel zu beseitigen und einen Golfschuh der eingangs geschilderten Art zu schaffen, der die an einen festen Schlagschuh genauso wie an einen bequemen Gehschuh gestellten Anforderungen bestens erfüllt und nicht nur einen sicheren, präzisen Schlag, sondern auch ein angenehmes, ermüdungsfreies Gehen erlaubt.

Die Erfindung löst diese Aufgabe dadurch, daß das in an sich bekannter Weise aus Weichschaum, wie PUR- oder PVC-Weichschaum oder aus Luft- bzw. Flüssigkeitspolstern oder dgl. bestehende Widerlager an der Sohlenoberseite vorgesehen ist, wobei das Widerlager eine Sohleneinlage bildet oder die Sohle selbst eine als Widerlager dienende Schicht aufweist.

Es entsteht ein Golfschuh mit funktionsabhängig relativ zur Sohle aus- und einfahrbaren Spikes. Beim Gehen wird nämlich die Sohle etwa gleichmäßig belastet und diese Lastverteilung ermöglicht es den Widerlagern, die auftretenden Kräfte ohne ein stärkeres Zusammendrücken aufzunehmen und die einzelnen Spikes in zurückgezogener Stellung zu halten. Der Golfschuh wirkt als Gehschuh mit entsprechender Lauffläche, die je nach Spikelänge keine oder nur wenig vorragende Spikes aufweist. Die federelastischen Widerlager fangen die Belastung auf und bieten dem Fuß eine weiche, gehfreundliche Unterstützung. Beim Schlagen hingegen ergeben sich durch die spezielle Dreh- und Rollbewegung des Fußes verstärkte Belastungen im Ballen- und Randbereich der Sohle und, da es keine Vergleichmäßigung durch eine zwischenliegende Sohle gibt, überfordert diese örtliche Belastungsverdichtung in den jeweiligen Sohlenbereichen die üblichen Abstützkräfte der Widerlager, so daß die Widerlager entsprechend weit zusammengedrückt und die Spikes ausgefahren werden. Der Golfschuh wirkt als Schlagschuh mit spikebestückter Sohle, wobei die Spikes vor allem an den Stellen stärkerer Belastung und in einer von der Belastungsstärke abhängigen Länge über die Lauffläche vorragen, so daß nicht nur ein ausgezeichneter, rutschfester Halt am Boden gewährleistet ist, sondern auch eine, das eigentliche Drehen und Rollen des Fußes beim Schlagen erleichternde Sohlenbewegung ohne jede Kippgefahr möglich wird. Da die Spikes demnach nur bedarfsweise, nämlich wenn aufgrund einseitiger Belastungen tatsächlich eine erhöhte Bodenhaftung notwendig ist, zum Einsatz kommen, bietet der erfindungsgemäße Golfschuh zum ermüdungsfreien, bequemen Gehen eine spikelose Laufsohle, gleichzeitig aber zum sicheren Schlagen oder anderen extremeren Bewegungen, wie Spring- und Sprintbewegungen, eine gespikte Sohle. Außerdem kann das federelastische Widerlager bestens in ein passendes Fußbett integriert werden, ist gut durch die darunterliegende Sohle geschützt und erlaubt auch die Verwendung einer gewünschten widerstandsfähigen Laufsohle. Bildet das Widerlager eine Sohleneinlage, läßt sich diese Sohleneinlage aufwandsarm in die Sohle integrieren und kann außerdem zur Schaffung eines bequemen Fußbettes beitragen. Weist die Sohle selbst eine als Widerlager dienende Schicht auf, ist es möglich, Sohle und Widerlager einstückig etwa aus unterschiedlich dichtem Schaumstoff herzustellen.

Ist die Druckplatte der Spikes an ihrer Oberseite dem jeweils darüberliegenden Bereich des Fußbettes oder der Brandsohle nachgeformt, werden Druckstellen auch bei längerer, stärkerer Belastung sicher vermieden und ein besonderer Tragkomfort erreicht.

Günstig ist es auch, wenn die Druckplatten eine Aufnahme für an sich bekannte auswechselbare Spikeschäfte aufweisen, da so verschieden lange Spikes eingesetzt werden können und die Ausfahrlänge damit an das jeweilige Körpergewicht des Spielers anzupassen ist. Selbstverständlich lassen sich auch durch unterschiedliche Gestaltung der Spikes die jeweiligen Bodenverhältnisse berücksichtigen.

Eine gute Bodenhaftung wird erreicht, wenn der Schaft der Spikes krallenförmig gekrümmt ist, wobei diese Schaftkrümmung vor allem durch die Ausfahrbarkeit der Spikes zum Tragen kommt.

In der Zeichnung ist der Erfindungsgegenstand rein schematisch dargestellt, und zwar zeigen

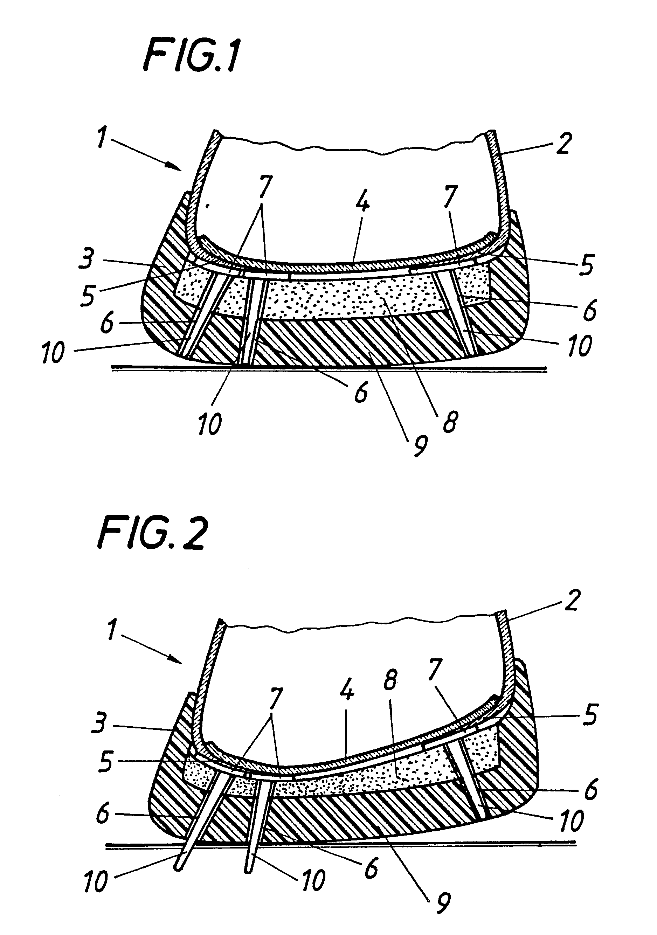

Fig. 1 und 2 einen erfindungsgemäßen Golfschuh bei gleichmäßiger und bei einseitiger Sohlenbelastung jeweils im Querschnitt.

Ein Golfschuh 1 besteht aus Oberteil 2 und Sohle 3, wobei Oberteil und Sohle miteinander über den von einer Brandsohle 4 abgedeckten Zwickeinschlag 5 verbunden sind. Um dem Golfschuh 1 die Eigenschaften eines bequemen Gehschuhes genauso wie die eines sicheren Schlagschuhes zu verleihen, nimmt die Sohle 3 axialbeweglichgeführte Spikes 6 auf, die sich sohlenoberseitig über Druckplatten 7 an einer als federelastisches Widerlager dienenden Sohleneinlage 8 aus Weichschaum abstützen. Diese axialbeweglichen Spikes 6 werden durch die zwischen den Druckplatten 7 und dem Laufflächenbereich 9 der Sohle 3 eingesetzte Sohleneinlage 8 bei gleichmäßiger Sohlenbelastung, beispielsweise durch eine Gehbewegung, in ihrer zurückgezogenen Lage abgestützt (Fig. 1), so daß sich der Golfschuh 1 ähnlich einem nicht gespikten Laufschuh verhält. Die Sohleneinlage 8 und eine entsprechende Formgebung der Druckplatten 7 ermöglichen dabei auch die Ausbildung eines nicht weiter dargestellten Fußbettes, das eine bequeme, Ermüdungen vorbeugende und Druckstellen vermeidende Fußauflage bietet.

Kommt es nun zu einer einseitigen Sohlenbelastung, beispielsweise durch die Fußbewegung beim Schlagen des Golfballes, wird die Sohleneinlage 8 im Bereich der Belastungsverdichtung über die Druckplatten 7 zusammengepreßt, wodurch die Spikeschäfte 10 aus dem Laufflächenbereich 9 der Sohle 3 heraustreten und für die gewünschte Bodenhaftung und Standsicherheit sorgen. Erst beim Schlagen werden daher die Spikes 6 zur Wirkung gebracht und gewährleisten dann an den Stellen der größten Belastung und damit auch der größten Rutschgefahr den erforderlichen Halt (Fig. 2).

Die Spikes 6, deren Schäfte 10 in ihrer Länge der Sohle 3 und der Dicke der Sohleneinlage 8 angepaßt sind, werden daher selbsttätig und vor allem auch lastabhängig aus- und eingefahren, so daß der Golfschuh 1 bedarfsweise als Laufschuh oder als Schlagschuh dient. Dabei können diese Spikes mit jeder beliebigen Lauffläche kombiniert werden, die allerdings zweckmäßig in ihrer Profilierung an diese Spikes angepaßt sein wird. Die Spikes selbst können ebenfalls verschiedenst ausgebildet und angeordnet sein, und auch die federelastische Abstützung für die Spikes läßt sich wunschgemäß variieren und an den jeweiligen Sohlenaufbau bzw. an das zu erwartende Körpergewicht anpassen.

## Patentansprüche

1. Golfschuh mit spikebestückter Sohle (9), wobei die aus Schaft (10) und Druckplatte (7) bestehenden Spikes (6) sich axialbeweglich über die Druckplatte (7) an einem federelastischen Widerlager (8) abstützen und mit ihrem Schaft (10) in Durchlaßöffnungen der Sohle (3) eingreifen, dadurch gekennzeichnet, daß das in an sich bekannter Weise aus Weichschaum, wie PUR- oder PVC-Weichschaum oder aus Luft- bzw. Flüssigkeitspolstern oder dgl. bestehende Widerlager (8) an der Sohlenoberseite vorgesehen ist, wobei das Widerlager eine Sohleneinlage (8) bildet oder die Sohle selbst eine als Widerlager dienende Schicht aufweist.

2. Golfschuh nach Anspruch 1, dadurch gekennzeichnet, daß die Druckplatte (7) der Spikes (6) an ihrer Oberseite dem jeweils darüberliegenden Bereich des Fußbettes oder der Brandsohle nachgeformt ist.

3. Golfschuh nach Anspruch 1 oder 2, dadurch gekennzeichnet, daß die Druckplatten eine Aufnahme für an sich bekannte, auswechselbare Spikeschäfte aufweisen.

4. Golfschuh nach einem der Ansprüche 1 bis 3, dadurch gekennzeichnet, daß der Schaft der Spikes krallenförmig gekrümmt ist.

## Claims

1. A golf shoe with a spiked sole (9), in which the spikes (6) consisting of a shank (10) and a pressure plate (7) bear against a resilient abutment (8) so as to be axially movable via the pressure plate (7) and engage by their shank (10) in passage apertures in the sole (3), characterised in that the abutment (8) which, in manner known per se, consists of soft foam, such as PUR or PVC soft foam, or of air or liquid cushions or the like, is provided at the top of the sole, the abutment forming a sole inlay (8) or the sole itself having a layer serving as abutment.

2. A golf shoe according to claim 1, characterised in that the pressure plate (7) of the spikes (6) is shaped at its top to the shape of that zone of the foot bed or insole which is situated thereabove.

3. A golf shoe according to claim 1 or 2, characterised in that the pressure plates have a holder for interchangeable spike shanks known per se.

4. A golf shoe according to any one of claims 1 to 3, characterised in that the shank of the spikes is curved to be claw-shaped.

**Revendications**

1. Chaussure de golf comprenant une semelle (9) pourvue de crampons, les crampons (6) formés d'une tige (10) et d'une plaque d'appui (7) s'appuyant contre un support (8) élastique de façon à pouvoir bouger en direction axiale et s'étendant avec leur tige (10) dans des passages dans la semelle (3), caractérisée en ce que le support (8), formé de façon connue de mousse molle, telle que la mousse molle de polyuréthane ou de chlorure de polyvinyl ou de coussinets d'air et de liquide, respectivement ou de matière similaire, est prévu sur la surface supérieure de la semelle, le support formant une doublure de semelle (8) ou la semelle étant pourvue elle-même d'une couche servant de support.

2. Chaussure de golf selon la revendication 1, caractérisée en ce que la plaque d'appui (7) des crampons (6) est formée à sa surface conformément à la zone d'appui du pied ou de la semelle intérieure qui lui fait face.

3. Chaussure de golf selon la revendication 1 ou 2, caractérisée en ce que les plaques d'appui sont pourvues d'un logement pour des tiges de crampon échangeables connues en soi.

4. Chaussure de golf selon l'une des revendications 1 à 3, caractérisée en ce que la tige des crampons est courbée en forme de griffe.

# FIG.1

# FIG.2